Europäisches Patentamt

**European Patent Office**

**Office européen des brevets**

(11) Numéro de publication: **0 354 858 B1**

## FASCICULE DE BREVET EUROPEEN

(45) Date de publication de fascicule du brevet: **15.12.93**   (51) Int. Cl.⁵: **H01L 27/10**, H01L 29/788, H01L 21/28, G11C 17/00

(21) Numéro de dépôt: **89420287.8**

(22) Date de dépôt: **31.07.89**

---

(54) **Mémoire de type EPROM à haute densité d'intégration et possédant un facteur de couplage élevé.**

---

(30) Priorité: **11.08.88 FR 8810963**

(43) Date de publication de la demande:
**14.02.90 Bulletin 90/07**

(45) Mention de la délivrance du brevet:
**15.12.93 Bulletin 93/50**

(84) Etats contractants désignés:
**DE FR GB IT NL**

(56) Documents cités:
**EP-A- 0 197 284**
**DE-A- 3 426 306**
**FR-A- 2 296 914**
**US-A- 4 258 466**

(73) Titulaire: **SGS-THOMSON MICROELECTRONICS S.A.**
**7, Avenue Gallièni**
**F-94250 Gentilly(FR)**

(72) Inventeur: **Bergemont, Albert**
**25, Chemin Pré Morin**
**F-38700 Corenc(FR)**

(74) Mandataire: **de Beaumont, Michel**
**1bis, rue Champollion**
**F-38000 Grenoble (FR)**

---

Rank Xerox (UK) Business Services
(3.10/3.6/3.3.1)

## Description

La présente invention concerne les mémoires à semiconducteur, et plus particulièrement les mémoires non-volatiles électriquement programmables, plus couramment appelées mémoires EPROM ; la fabrication des mémoires à grille flottante est plus précisément concernée.

Pour obtenir des mémoires de grande capacité de stockage, par exemple des mémoires capables de stocker jusqu'à 16 mégabits, on doit réduire le plus possible la dimension de chacune des cellules constituant la mémoire.

Mais on est évidemment limité par des considérations physiques, et notamment par la finesse des motifs que permettent les étapes de photolithographie ; on est limité aussi par les paramètres électriques parasites qui sont dus au processus de fabrication et qui perturbent le fonctionnement de la mémoire.

Sauf quelques exceptions qui n'ont pas encore eu de succès industriel, toutes les approches essayées pour conduire à des mémoires de grande capacité telles que décrites dans US-A-4 258 466 correspondent à une technologie dont les points essentiels sont les suivants :

- le point-mémoire individuel est constitué d'un transistor ayant une grille flottante réalisée par un premier niveau de silicium polycristallin et une grille de commande réalisée par un deuxième niveau de silicium polycristallin ;
- les sources des transistors sont connectées à un bus à potentiel bas Vss ;
- la ligne de mot pour désigner une ligne de cellules est constituée du deuxième niveau de silicium polycristallin ;
- la ligne de bit pour lire l'état d'une cellule est constituée d'une ligne de métal (aluminium) croisant les lignes de mot et contactant de place en place le drain des transistors ;
- pour réduire la taille du point-mémoire, on prévoit qu'un seul point de contact est prévu pour deux drains adjacents de deux transistors d'une même colonne, ce contact assurant la connexion à la ligne de bit ; de même, on prévoit un seul contact entre les sources de deux transistors adjacents et le bus à Vss ;
- les transistors sont séparés les uns des autres par de l'oxyde de silicium épais (comparativement à l'oxyde de grille des transistors), et les lignes de bit et les lignes de mot passent au-dessus de cet oxyde épais ;
- enfin, l'écriture d'une information dans une cellule de la mémoire se fait de la manière suivante : les sources de tous les transistors de la mémoire sont à un potentiel bas Vss (par exemple zéro voit) ; la ligne de mot connectée à la grille de commande de la cellule à programmer est portée à un potentiel de programmation Vpp (par exemple 15 volts), tandis que toutes les autres lignes de mot sont au potentiel bas Vss ; la ligne de bit correspondant au point à programmer est portée à un potentiel haut Vcc (par exemple 10 volts), tandis que les lignes de bit des points qui ne doivent pas être programmés sont maintenues au potentiel bas Vss.

Avec cette architecture de mémoire et le mode de programmation associé, il est impératif que le drain d'un transistor soit électriquement isolé, par de l'oxyde épais, du drain des transistors adjacents de la même ligne de mot, faute de quoi on ne pourrait programmer un point-mémoire particulier sans programmer ou déprogrammer en même temps les autres.

Mais l'oxyde épais qui isole deux points adjacents occupe beaucoup de place, surtout lorsqu'il est réalisé par la technique dite d'oxydation localisée.

On a essayé de remplacer l'oxydation localisée par une isolation par tranchées remplies d'oxyde, pour réduire l'encombrement global de la cellule, mais cette technologie n'est pas industriellement au point.

On a également proposé (demande de brevet français 86/12940) des structures où les zones d'oxyde épais et les contacts multiples vers les drains ou sources sont supprimés. Ces structures permettent effectivement une miniaturisation du réseau mémoire mais au prix d'une complexification du système d'adressage et donc d'une augmentation de la surface occupée par celui-ci.

Pour réduire l'encombrement des cellules et ainsi augmenter la capacité de stockage de la mémoire, la présente invention propose une nouvelle architecture de mémoire qui permet de ne prévoir une telle zone d'oxyde épais que tous les deux transistors connectés à une même ligne de mot. De plus, la nouvelle architecture proposée permet d'éviter la présence de contacts sur les lignes de bit entre les cellules.

Selon l'invention, la mémoire est composée d'un réseau de lignes de mot s'étendant suivant une première direction, dite de rangée, reliant des grilles de commande de transistors à grille flottante, et de lignes de bit s'étendant suivant une deuxième direction, dite de colonne, reliant des drains des transistors à grille flottante. Une zone conductrice respective, de dimensions supérieures à celles de la grille flottante des transistors suivant un plan horizontal, est reliée à la grille flottante de chaque transistor de la mémoire, tout en étant située en regard de la ligne de mot correspondante dont elle est séparée par une couche d'isolement.

Selon un autre aspect de la présente invention, il est prévu un procédé de fabrication de mémoire, de type MOS à transistors à grille flottante disposés selon des rangées et des colonnes sur un substrat d'un premier type de conductivité, comprenant les étapes suivantes :

- réaliser des zones d'oxyde épais selon des colonnes,
- déposer et graver un premier niveau de silicium polycristallin pour former selon des colonnes d'une part deux premières bandes adjacentes entre chaque paire de colonnes d'oxyde épais, d'autre part deux deuxièmes bandes dont chacune est à cheval entre la partie comprise à l'intérieur de cette paire et une partie de la zone d'oxyde épais correspondante,
- réaliser une implantation du deuxième type de conductivité en utilisant le premier niveau de silicium polycristallin comme masque,
- former une couche d'isolement entre les différentes zones de premier niveau de silicium polycristallin,
- déposer un deuxième niveau de silicium polycristallin et l'isoler superficiellement,
- graver le deuxième niveau de silicium polycristallin (35) pour qu'il recouvre selon des colonnes des première et deuxième bandes adjacentes du premier niveau de silicium polycristallin,
- isoler latéralement les régions apparentes du deuxième niveau de silicium polycristallin,
- déposer un troisième niveau de silicium polycristallin,
- graver par un même masque, selon des rangées, les trois niveaux de silicium polycristallin,
- former une couche isolante, et
- établir des contacts avec les bandes restantes du troisième niveau de silicium polycristallin (lignes de mot), les colonnes de drains (lignes de bit), et les colonnes de sources (lignes à potentiel constant).

Ces objets, caractéristiques et avantages ainsi que d'autres de la présente invention seront exposés plus en détail dans la description suivante d'un mode de réalisation particulier faite en relation avec les figures jointes parmi lesquelles :

les figures 1A et 1B représentent une cellule élémentaire de mémoire classique, la figure 1A étant une représentation sous forme de schéma électrique et la figure 1B étant une vue en coupe schématique de la cellule élémentaire ;

la figure 2 représente une vue de dessus de l'implantation de six points mémoires adjacents sur une tranche de silicium selon l'art antérieur ;

la figure 3 représente une vue en coupe suivant l'axe YY′ de la figure 2 ;

la figure 4 représente une vue en coupe suivant l'axe ZZ′ de la figure 2 ;

les figures 5A et 5B représentent chacune une vue de dessus de l'implantation de quatre points-mémoire adjacents sur une tranche de silicium selon la présente invention, à deux étapes de fabrication différentes ;

les figures 6A à 6G représentent les différentes étapes du procédé de fabrication selon l'invention ;

la figure 7 représente une vue en coupe suivant l'axe ZZ′ de la figure 5B ;

les figures 8A et 8B représentent chacune un schéma des capacités existant à l'emplacement d'un transistor, suivant deux modes de réalisation différents ; et

la figure 9 représente une variante de réalisation de l'invention.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

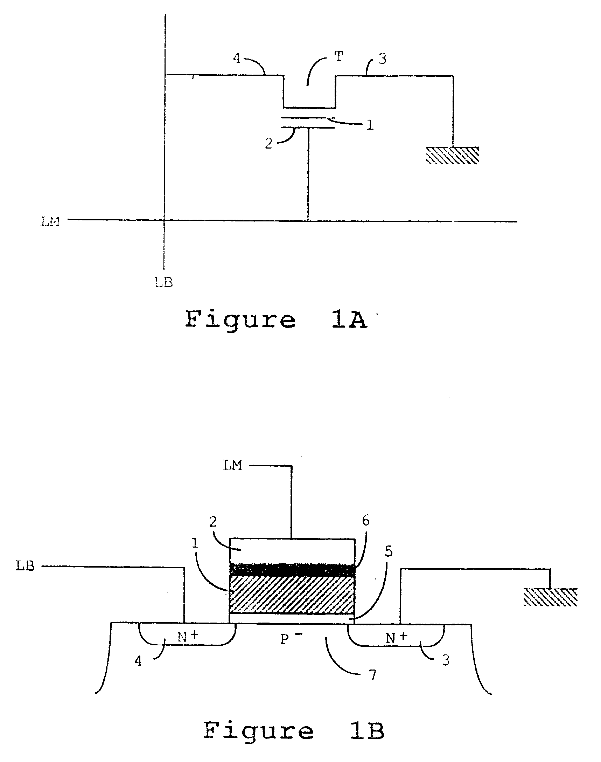

La figure 1A représente un transistor T d'un point-mémoire à grille flottante. Ce transistor possède une grille flottante 1 et une grille de commande 2, ainsi que deux régions semiconductrices d'un premier type de conductivité (source 3 et drain 4) séparées par une région de canal d'un type de conductivité opposé recouverte par la grille flottante 1 et la grille de commande 2.

La grille de commande 2 est reliée à une ligne de mot LM. Le drain 4 est relie à une ligne de bit LB.

Pour programmer, ou écrire, un tel point-mémoire, on charge sa grille flottante 1 par injection de porteurs chauds, en appliquant à la grille de commande 2, pendant que le transistor conduit un courant entre ses régions de source 3, mises à la masse, et de drain 4, un potentiel suffisamment élevé pour que les porteurs de charge (électrons) soient attirés et piégés dans la grille flottante. Cette opération d'écriture a pour effet d'augmenter le seuil de conduction du transistor qui, une fois programmé, ne conduira le courant que pour des valeurs de potentiel appliqué sur la grille de commande plus élevées qu'en l'absence de programmation.

Lors de la lecture de l'information contenue dans un point-mémoire, on applique à la grille de commande du transistor de ce point-mémoire une tension à la fois supérieure à la tension de seuil de déclenchement de conduction à l'état non-programmé et inférieure à la tension de seuil de déclenchement de conduction à l'état programmé.

Si le transistor conduit le courant quand une différence de potentiel adaptée est appliquée entre la source et le drain, le point-mémoire est à l'état non-programmé. Si le transistor ne conduit pas le courant, le point-mémoire est à l'état programmé.

Le potentiel appliqué à la grille de commande lorsqu'on programme le point-mémoire, ou potentiel de programmation Vpp, est par exemple de 15 volts. Le potentiel de drain Vcc est alors par exemple de 10 volts, et le potentiel de source Vss est par exemple zéro volt, ou la masse.

Le potentiel appliqué à la grille de commande lors de la lecture du point-mémoire est par exemple de 5 volts. Le potentiel de drain Vcc est alors par exemple de 1,5 volts, et le potentiel e source Vss est par exemple zéro volt, ou la masse.

Sur la figure 1B, qui représente une vue en coupe d'un point-mémoire implanté sur une tranche de silicium, on retrouve la grille flottante 1 et la grille de commande 2 du transistor. On voit également la source 3 et le drain 4, qui sont deux régions semiconductrices d'un premier type de conductivité, par exemple N+, séparées par une région de canal 7 d'un type de conductivité opposé, par exemple P−.

La grille flottante 1 du transistor est réalisée par un premier niveau de silicium polycristallin (poly 1). Elle est séparée du substrat par une couche de dioxyde de silicium 5, également appelée couche d'oxyde de grille.

Au-dessus de la grille flottante 1, on trouve une couche de dioxyde de silicium 6. Cette couche est située entre la grille flottante 1 et la grille de commande 2, cette dernière étant réalisée par un deuxième niveau de silicium polycristallin (poly 2). La couche de dioxyde de silicium 6 porte ainsi également le nom de couche d'oxyde interpoly.

Dans la mémoire, la grille de commande 2 du transistor est reliée à une ligne de mot LM. La source 3 est reliée à la masse, et le drain 4 à une ligne de bit LB.

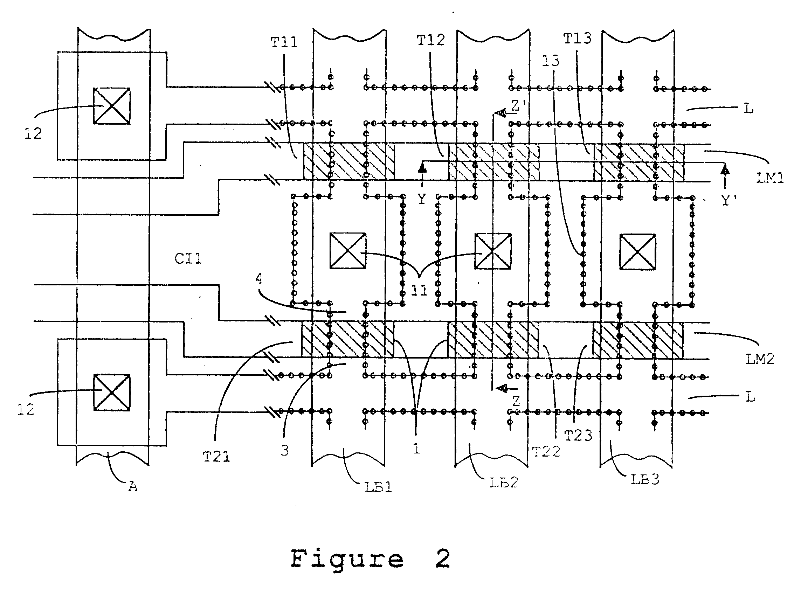

La figure 2 représente en vue de dessus un mode d'implantation classique de six points-mémoire adjacents sur une tranche de silicium.

On désigne par Tij les différents transistors à grille flottante constituant le réseau de points-mémoire, où i est un indice de rangée et j un indice de colonne.

Ainsi, les transistors T11 à T13 sont ceux de la première rangée, les transistors T21 à T23 sont ceux de la deuxième rangée.

De même, les transistors T11 et T21 sont ceux de la première colonne, les transistors T12 et T22 sont ceux de la deuxième colonne et enfin les transistors T13 et T23 sont ceux de la troisième colonne.

Les grilles de commande des transistors d'une même rangée sont toutes reliées à une même ligne de mot, LM1 et LM2 pour les rangées 1 et 2, respectivement.

Les drains des transistors d'une même colonne sont tous reliés à une même ligne de bit, LB1 à LB3 pour les colonnes 1 à 3, respectivement.

Les lignes de mot sont des conducteurs (en pratique en silicium polycristallin) s'étendant selon une direction horizontale (direction des rangées). Les lignes de bit sont des conducteurs s'étendant dans une direction verticale (direction des colonnes).

Les lignes de bit passent au-dessus des transistors Tij formant les points-mémoire.

Elles sont reliées aux drains 4 des transistors par des contacts 11. Les grilles flottantes 1 des transistors sont situées entre les drains 4 et les sources 3.

Les sources des transistors d'une même rangée sont toutes reliées à une ligne commune L. couple de deux rangées de transistors, séparé d'un couple adjacent par une rangée de contacts 11, partage une ligne commune L unique, qui est placée entre les deux rangées.

Toutes les lignes communes L sont reliées par un contact 12 à une ligne conductrice A qui, étant elle-même au potentiel de source Vss, permet d'appliquer aux sources des transistors la tension Vss.

Une zone d'isolement 13 est située entre chaque ligne commune L et entre chaque colonne de transistors. En pratique, la zone d'isolement est réalisée en oxyde de silicium épais (comparativement à l'oxyde de grille).

La grille flottante 1 des transistors déborde sur la zone d'isolement.

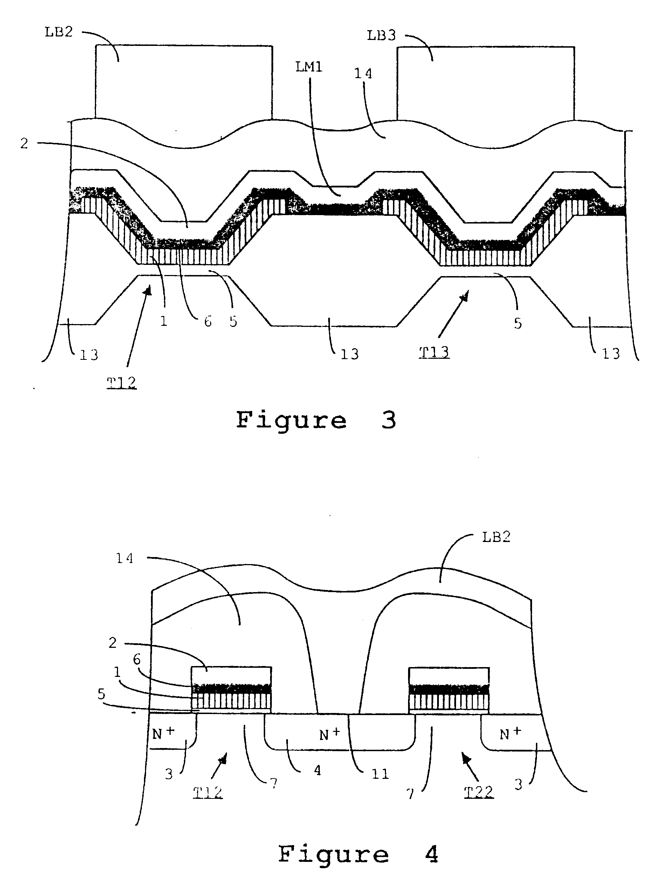

Deux transistors, par exemple les transistors T12 et T13, sont représentés sur la figure 3 qui est une coupe suivant l'axe YY′ de la figure 2.

Ils sont séparés par une zone d'isolement 13. Sous la grille flottante 1 se trouve la couche d'oxyde de grille 5. La grille flottante 1 a des dimensions plus grandes suivant cette direction de coupe que la couche d'oxyde de grille 5, et elle déborde sur les zones d'isolement. On observe au-dessus de la grille flottante la couche d'oxyde interpoly 6. La ligne de mot LM1 court le long de la rangée de transistors et fait office de grille de commande 2 à l'emplacement des transistors.

La ligne de mot LM1 est recouverte par une couche isolante 14. Cette couche isolante 14 est par exemple réalisée en oxyde de silicium dopé au bore et au phosphore (BPSG) qui permet d'obtenir un bon fluage à faibles températures (d'environ 850 à 950 °C).

Les lignes de bit LB2 et LB3 sont situées sur la couche isolante 14, au-dessus des transistors T12 et T13 respectivement.

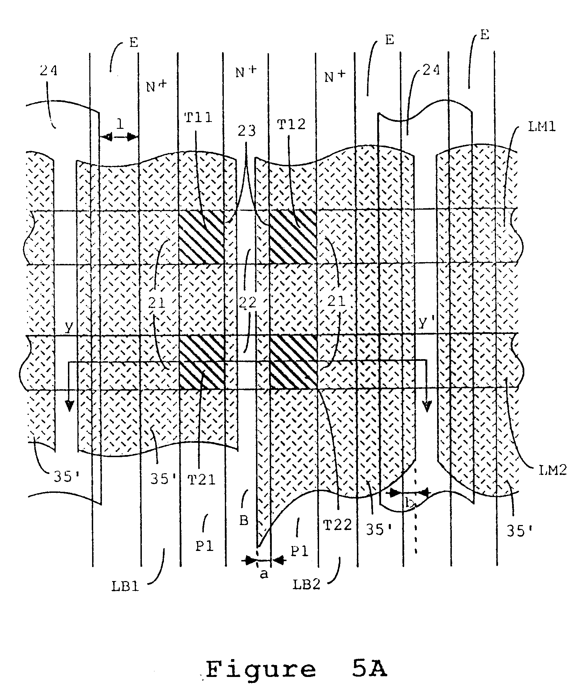

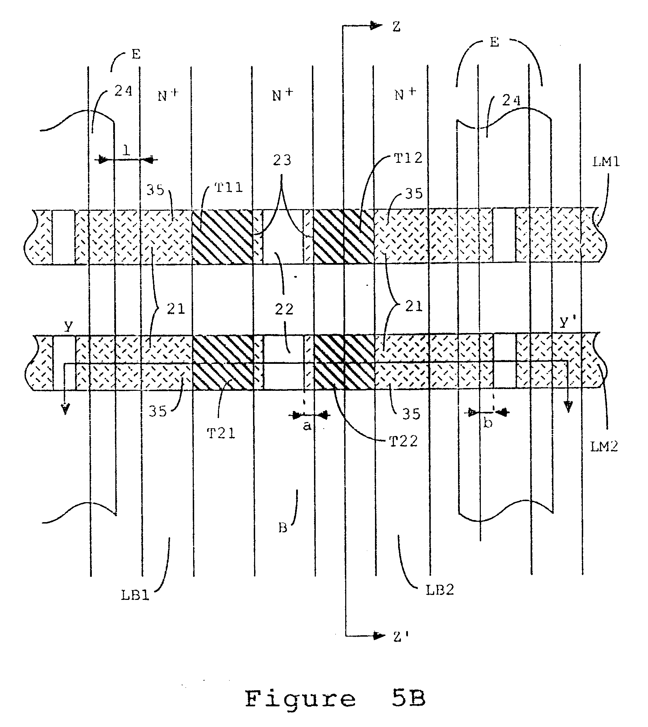

On voit sur la figure 4, qui représente une vue en coupe suivant l'axe ZZ' de la figure 2, les deux transistors T12 et T22.

Comme cela a été montré sur la figure 1B, chaque transistor comprend une région de source 3 et une région de drain 4 séparées par une région de canal 7, ainsi que la superposition des couches formant l'oxyde de grille 5, la grille flottante 1, l'oxyde interpoly 6 et la grille de commande 2.

Les grilles de commande des transistors sont recouvertes par la couche isolante 14. La ligne de bit LB2 est reliée aux drains des deux transistors par le contact 11.

L'architecture classique, telle qu'on vient de la décrire, présente cependant des éléments qui limitent la réduction des dimensions. D'une part, on trouve une série de contacts entre lignes de bit et régions de drains toutes les deux rangées de transistors. D'autre part, on voit sur la figure 2 qu'une zone d'isolement 13, réalisée en oxyde de silicium épais, est située entre chaque paire de lignes communes 2 et entre chaque paire de colonnes de transistors.

Egalement, on voit sur la figure 4 un passage de marche de la ligne de bit LB2 lors de sa prise de contact avec les régions de drains des transistors T12 et T22. Toutes les lignes de bit, réalisées par exemple en aluminium, vont être soumises à des passages de marche toutes les deux rangées de transistors, ce qui constitue un risque important de cassure des lignes d'aluminium.

La présente invention propose une architecture qui évite ces inconvénients et a l'avantage de présenter un facteur de couplage élevé.

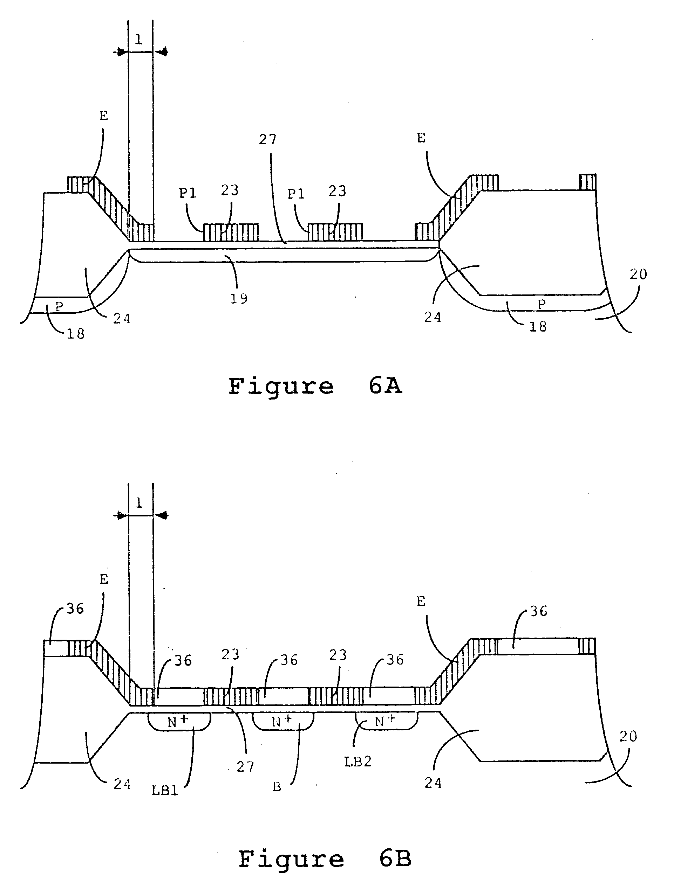

Cette architecture est représentée en vue de dessus aux figures 5A et 5B. La figure 5A représente la structure à un stade intermédiaire de fabrication après dépôt de deux niveaux de silicium polycristallin. La figure 5B représente la structure après dépôt d'un troisième niveau de silicium polycristallin et gravure des divers niveaux de silicium polycristallin. Les transistors sont toujours disposés en réseau de rangées et colonnes, les transistors de la première rangée étant encore désignés par T11 et T12, ceux de la deuxième rangée par T21 et T22, et le transistor Tij désignant plus généralement le transistor qui est au carrefour de la rangée i et de la colonne j.

Les grilles de commande des transistors de la rangée i sont encore toutes reliées à un conducteur de direction générale horizontale appelé ligne de mot LMi. Les lignes de mot sont encore des conducteurs (en pratique en silicium polycristallin) s'étendant selon une direction horizontale (direction des rangées).

Les lignes de bit LBj sont constituées de régions du substrat d'un premier type de conductivité, par exemple n$^+$. Chaque ligne de bit fait directement office de drain 21 à l'emplacement de chaque transistor. Il n'y a donc plus besoin de prévoir un contact toutes les deux rangées de transistors sur chacune des lignes de bit (contacts désignés par 11 sur la figure 2).

Des lignes à potentiel constant, conductrices, de direction générale verticale, sont intercalées une fois sur deux entre deux lignes de bit, elles sont désignées par B. Ces lignes à potentiel constant B sont constituées par des régions du premier type de conductivité, comme les lignes de bit LBj, et elles font office de sources 22 aux emplacements des transistors.

De chaque côté des deux lignes de bit LB1 et LB2, représentées sur les figures 5A et 5B, qui sont situées de part et d'autre de la même ligne à potentiel constant B, se trouvent des zones d'isolement 24, qui sont en principe réalisée en oxyde de silicium épais.

Les grilles flottantes 23 des transistors sont réalisées par un premier niveau de silicium polycristallin (poly 1) et situées de chaque côté de chaque ligne à potentiel constant B.

Des zones E, réalisées par le premier niveau de silicium polycristallin, recouvrent les bords adjacents aux colonnes de transistors des zones d'isolement (24) et en débordent d'une longueur 1. Les grilles flottantes 23 font encore partie, au stade de fabrication représenté à la figure 5A, de bandes de poly 1 désignées par P1 qui s'étendent suivant la direction des colonnes. Au stade de la fabrication présenté à la figure 5B, les bandes de poly 1 P1 ont été gravées et les grilles flottantes 23 sont formées de façon définitive par des rectangles de poly 1.

Sur la figure 5A, une couche 35' réalisé par le deuxième niveau de silicium polycristallin (poly 2) est reliée à chaque bande de poly 1 P1 en s'étendant suivant la direction des colonnes. Les couches 35' ont une largeur plus importante que celle des bandes de poly 1 P1. Sur la figure 5B, on observe des zones 35 constituées par le poly 2 qui sont la partie restante de la couche 35' après gravure de celle-ci. Chaque zone 35 est reliée à une grille flottante 23. Les dimensions suivant la direction des colonnes des zones 35 sont identiques à celles des grilles flottantes 23, et les dimensions suivant la direction des rangées des zones 35 sont supérieures à celles des grilles flottantes 23. Suivant la direction des rangées, les zones 35 débordent des grilles flottantes 23, du côté des régions de sources 22, d'une longueur a, et les zones 35 passent au-dessus des zones E et en débordent d'une longueur b.

Les lignes de mot LM1 et LM2 sont constituées par un troisième niveau de silicium polycristallin (poly 3).

Puisque la source et le drain d'un transistor sont disposés selon une direction horizontale, le courant dans le canal circulera dans la direction horizontale, ou direction des lignes de mot, et ainsi, le transistor possèdera une région de canal orientée dans le même sens que les lignes de mot.

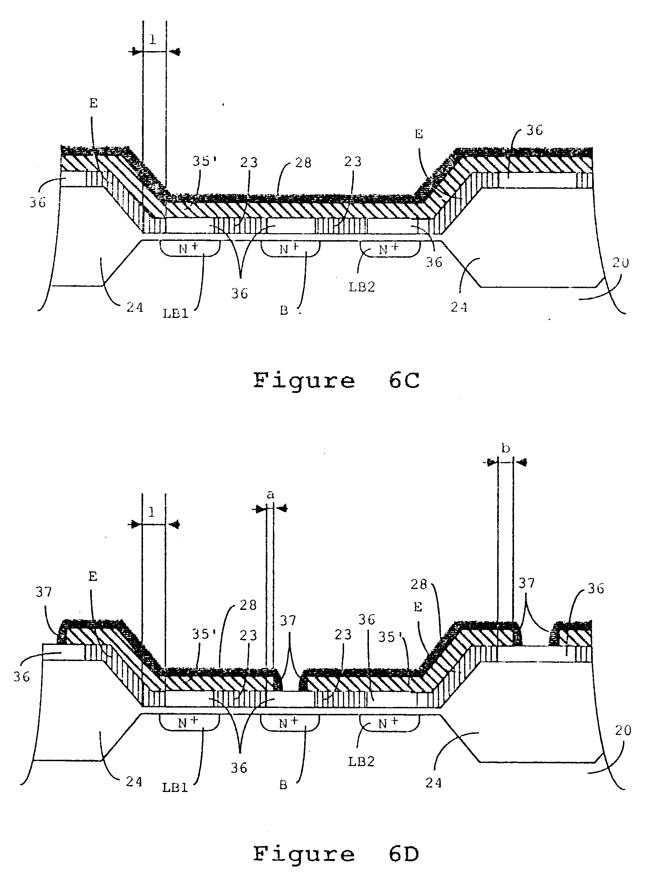

Les figures 6A à 6G représentent des vues en coupe suivant l'axe YY' des figures 5A ou 5B, elles correspondent chacune à une étape du procédé de fabrication de la structure selon l'invention réalisée dans un substrat de silicium 20.

La figure 6A représente la structure à une étape préliminaire après réalisation des zones d'oxyde épais 24 et des couches d'oxyde de grille 27, après dépôt et gravure du premier niveau de silicium polycristallin pour former d'une part des bandes de poly 1 P1 dans lesquelles seront définies ultérieurement les grilles flottantes 23 des transistors et d'autre part les zones E. Les zones d'oxyde épais 24 ont par exemple une épaisseur de 700 nm et les couches d'oxyde de grille 27 ont par exemple une épaisseur de 20 nm. De façon classique, des régions 18 de type P sont situées sous les zones d'oxyde épais 24. Ces régions 18 sont couramment appelées régions d'arrêt de canal. On a également représenté des régions dopées 19 situées sous les couches d'oxyde de grille 27 pour définir le seuil de déclenchement des transistors de la mémoire.

Pour une plus grande clarté des dessins, les régions 18 et 19 ne seront pas représentées sur les figures 6B à 6G.

La figure 6B représente la structure à une étape intermédiaire après formation de régions de type N$^+$ fortement dopées qui constituent d'une part les lignes de bit LBj et d'autre part les lignes à potentiel constant B. Ces régions sont réalisées par implantation d'arsenic.

La figure 6B représente également la structure après dépôt d'une couche d'isolement 36 entre les différentes zones de poly 1. De façon classique, un procédé de planarisation est utilisé pour que les surfaces supérieures de cette couche 36 et du premier niveau de silicium polycristallin soient au même niveau. Cette couche 36 est constituée d'oxyde de silicium obtenu par exemple par dépôt en phase vapeur à partir d'une source TEOS (tétraéthyle ortho silicate).

La figure 6C représente la structure à une étape intermédiaire après dépôt du deuxième niveau de silicium polycristallin 35' et réalisation d'une couche d'isolant 28, que l'on appelle couramment couche d'oxyde interpoly, et qui est constituée dans cette structure par un empilement de trois couches oxyde de silicium/nitrure de silicium/oxyde de silicium appelé ONO.

La figure 6D représente la structure à une étape intermédiaire après gravure de la couche d'oxyde interpoly 28 et du deuxième niveau de silicium polycristallin 35' au niveau d'une part de la couche d'isolement 36 située à l'emplacement des lignes à potentiel constant B et d'autre part de la couche d'isolement 36 située au-dessus des zones d'oxyde épais 24.

La figure 6D représente également la structure après réalisation d'une zone d'oxyde 37, appelée zone d'oxyde de coin, à chaque extrémité, suivant la direction des rangées, des couches 35' définies par la gravure.

La figure 6E représente la structure à une étape intermédiaire après dépôt du troisième niveau de silicium polycristallin (poly 3) à partir duquel sont formées les lignes de mot LMi, et gravure du poly 3, de la couche d'oxyde interpoly ONO 28, du poly 2 et poly 1 qui permet de définir les lignes de mot LMi formées dans le poly 3, les zones 35 formées dans les couches 35', et les grilles flottantes 23 formées dans les bandes de poly 1 P1.

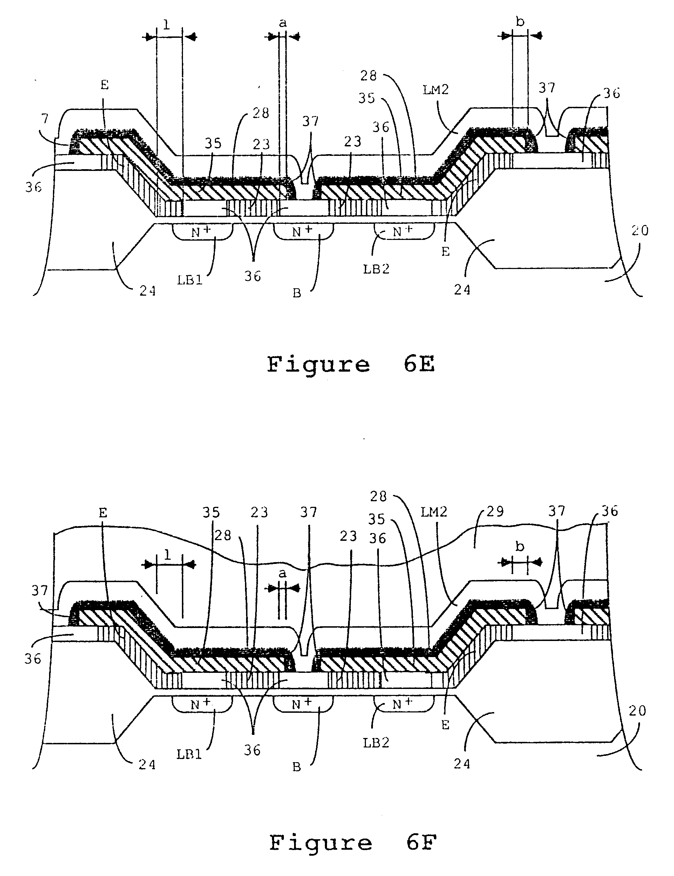

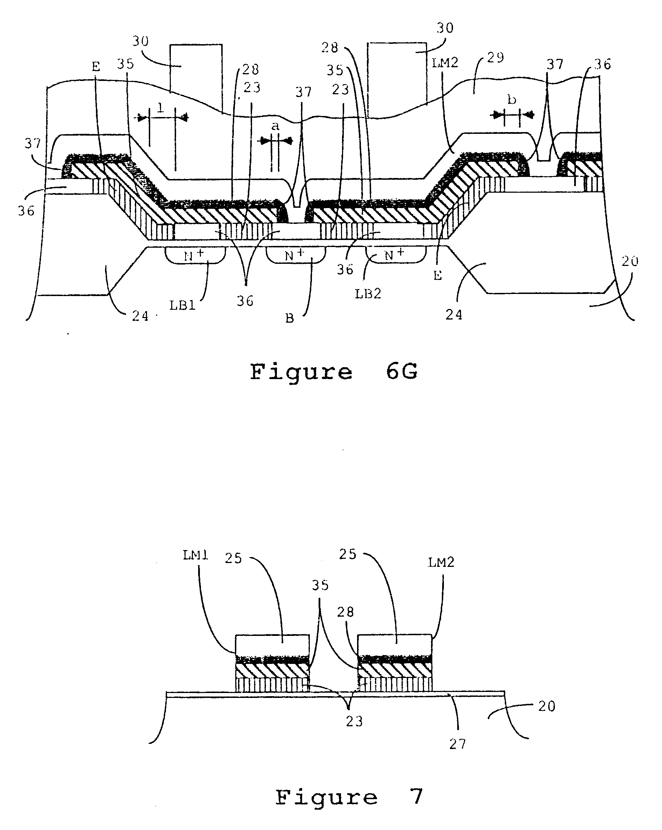

La structure obtenue après la gravure de ces différentes couches peut également être observée sur la figure 7, qui représente une vue en coupe suivant l'axe ZZ' de la figure 5B.

Il apparaît de plus sur la figure 6E que la couche d'oxyde interpoly ONO 28 et les zones d'oxyde de coin 37 assurent l'isolation entre les lignes de mot et les zones 35.

La figure 6F représente la structure à une étape intermédiaire après dépôt d'une couche isolante 29. Cette couche 29 est par exemple réalisée en oxyde de silicium dopé au bore et au phosphore (BPSG).

La figure 6G représente la structure à l'étape finale après réalisation de lignes conductrices 30 situées sur la couche isolante 29 et constituées par exemple en aluminium, chacune étant placée au-dessus d'une ligne de bit.

Elles sont connectées à des lignes de bit d'autres blocs mémoire (en effet, les points-mémoire sont habituellement regroupés en blocs occupant un certain nombre de rangées et de colonnes) permettant ainsi d'appliquer le potentiel désiré à ces lignes de bit et aux drains des transistors auxquels les lignes de bit sont reliées.

Les lignes conductrices 30 s'étendent sur une surface plane, ce qui permet d'éviter les problèmes dus aux passages de marche auxquels sont soumises les lignes d'aluminium dans la configuration classique.

De plus, l'espace existant entre les paires de lignes conductrices 30 est supérieur à l'espace existant entre les paires de lignes d'aluminium constituant les lignes de bit dans la configuration classique.

Sur la figure 7, qui représente une vue en coupe suivant l'axe ZZ' de la figure 5B, on voit les grilles flottantes 23 des transistors, ces grilles flottantes étant situées au-dessus de la couche d'oxyde de grille 27. On observe également les zones 35 formées par le deuxième niveau de silicium polycristallin, et les couches d'oxyde interpoly ONO 28 situées au-dessus des zones 35. On observe aussi les deux lignes de mot LM1 et LM2 qui font office de grilles de commande 25 à l'emplacement des transistors.

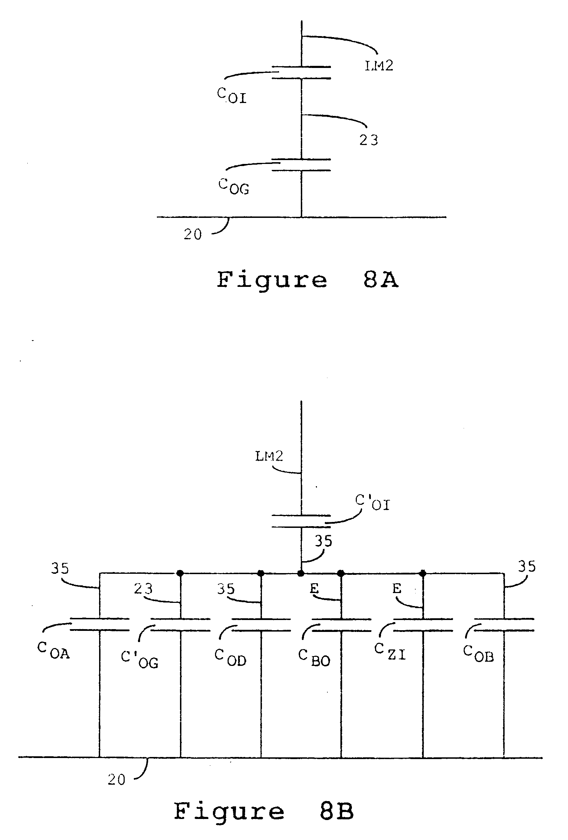

La figure 8A représente un schéma des capacités existant à l'emplacement d'un transistor dans le cas où l'architecture ne présente pas de zone 35 reliée à la grille flottante 23 du transistor, et la figure 8B représente un schéma des capacités existant à l'emplacement d'un transistor dans le cas de l'architecture selon l'invention.

Dans les deux cas, si l'on applique une tension $V_M$ à la ligne de mot LM2, on obtient la tension $V_F$ sur la grille flottante en calculant le facteur de couplage $\gamma$ qui relie ces deux tensions par la relation :

$$V_F = \gamma\, V_M$$

et qui est défini par le rapport entre la capacité au niveau de la couche d'oxyde interpoly et la somme de toutes les capacités présentes.

Si l'on considère la figure 8A, on observe la capacité au niveau de la couche d'oxyde interpoly 28 notée $C_{OI}$ et située entre la ligne de mot LM2 et la grille flottante 23. On a aussi une capacité $C_{OG}$ au niveau de la couche d'oxyde de grille 27 située entre la grille flottante 23 et le substrat 20.

Le facteur de couplage $\gamma$ s'écrit :

$$\gamma = C_{OI}/(C_{OI} + C_{OG}).$$

On peut calculer une valeur numérique représentative du facteur de couplage en utilisant des valeurs usuelles pour les dimensions des éléments concernés :
- longueur de la grille flottante suivant la direction des rangées : 0,8 micromètre.
- épaisseur de la couche d'oxyde interpoly : 20 nm
- épaisseur de la couche d'oxyde de grille : 20 nm

La valeur numérique du facteur de couplage est alors égale au rapport entre les quantités 0,8/20 et 0,8/20 + 0,8/20. Le facteur de couplage est alors égal à 0,5.

Si l'on considère la figure 8B, correspondant au cas où la zone 35 est reliée à la grille flottante du transistor, il apparaît de nouveau une capacité au niveau de la couche d'oxyde interpoly 28 notée $C'_{OI}$ et située entre la ligne de mot LM2 et la zone 35. On a aussi de nouveau une capacité au niveau de la couche d'oxyde de grille 27 notée $C'_{OG}$. Il existe également une capacité $C_{OA}$ correspondant à la partie de zone 35 qui déborde au-delà de la grille flottante 23 d'une longueur a suivant la direction des rangées, une capacité $C_{OD}$ au niveau de la partie d'oxyde de type TEOS séparant la grille flottante 23 et la zone E, une capacité $C_{BO}$ correspondant à la partie de la zone E qui déborde d'une longueur 1 au-delà des zones d'isolement 24, au niveau de la partie de la couche d'oxyde de grille 27 située entre la partie de zone E qui déborde et le substrat 20, une capacité $C_{ZI}$ correspondant à la partie de zone E située au-dessus de la zone d'isolement 24, au niveau de cette zone d'isolement 24, et une capacité $C_{OB}$ correspondant au débordement de la zone 35 au-delà de la zone E d'une longueur b, au niveau de la partie d'oxyde de type TEOS séparant deux zones E et de la zone d'isolement 24.

Le facteur de couplage s'écrit :

$$\gamma = C'_{OI}/(C'_{OI} + C_{OA} + C'_{OG} + C_{OD} + C_{BO} + C_{ZI} + C_{OB})$$

On peut calculer une valeur numérique représentative du facteur de couplage en utilisant les valeurs usuelles suivantes :
- débordement de la zone 35 au-delà de la grille flottante suivant la direction des rangées, désigné par a : 0,2 micromètre
- longueur de la grille flottante suivant la direction des rangées : 0,8 micromètre
- longueur de la partie d'oxyde de type TEOS qui sépare la grille flottante 23 de la zone E : 0,8 micromètre
- débordement de la zone E au-delà de la zone d'isolement 24 suivant la direction des rangées : 0,4 micromètre
- longueur de la zone E suivant la direction des rangées : 0,8 micromètre
- débordement de la zone 35 au-delà de la zone E suivant la direction des rangées, désigné par b : 0,2 micromètre
- épaisseur de la couche d'oxyde interpoly : 20 nm
- épaisseur de la couche d'oxyde de grille : 20 nm
- épaisseur de l'oxyde de type TEOS : 200 nm
- épaisseur de la zone d'isolement : 700 nm

La valeur numérique du facteur de couplage est alors égale au rapport entre les quantités (0,2 + 0,8 + 0,8 + 0,8 + 0,2)/20 et (0,2 + 0,8 + 0,8 + 0,8 + 0,2)/20 + 0,2/(200 + 20) + 0,8/20 + 0,8/(200 + 20) + 0,4/20 + 0,4/700 + 0,2/(200 + 700).

Le facteur de couplage est alors sensiblement égal à 0,70.

Cette architecture, par la présence de la zone 35 reliée à la grille flottante 23 du transistor, permet ainsi d'obtenir un facteur de couplage nettement amélioré.

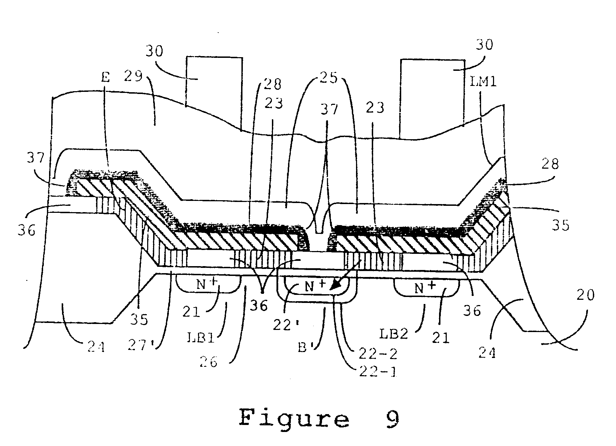

La figure 9 représente une variante de l'invention. On retrouve sur cette figure, qui est une vue en coupe analogue à la vue représentée à la figure 6G, les différents éléments constituant l'architecture selon l'invention, les principaux étant :

- une grille flottante 23, réalisée par un premier niveau de silicium polycristallin, à l'emplacement de chaque transistor ;
- deux lignes de bit LB1 et LB2, qui font office de drain 21 à l'emplacement des transistors ;
- deux zones d'isolement 24, en oxyde de silicium épais ;
- une ligne de mot LM1, réalisée par un troisième niveau de silicium polycristallin, qui fait office de grille de commande 25 à l'emplacement des transistors ;
- une ligne à potentiel constant, qui est désignée ici par B′, et qui a cependant une structure différente de celle représentée sur la figure 6G.

D'après la présente variante de l'invention, la couche d'oxyde de grille, que l'on désigne sur la figure 9 par 27′, est très mince par rapport aux valeurs usuelles, elle a par exemple une épaisseur de l'ordre de 10 nm.

La ligne à potentiel constant B′ est constituée de deux parties dopées à un degré différent. Il existe une première partie 22-1 fortement dopée, le dopage étant par exemple $N^+$ ; cette première partie est située dans un caisson 22-2 de même type de conductivité à faible dopage, le dopage étant alors par exemple $N^-$.

La ligne à potentiel constant B′ fait encore office de source 22′ à l'emplacement des transistors.

Cette nouvelle disposition permet, si une tension suffisamment élevée est appliquée à la source 22′, le transfert par effet tunnel de porteurs de charge, piégés lors d'une opération de programmation dans la grille flottante des transistors, de la grille flottante à la partie de la source à haut dopage. Ce transfert est rendu possible par la grande minceur de la couche d'oxyde de grille, il est représenté par la flèche sur la figure 9. La présence de la deuxième partie faiblement dopée permet d'augmenter la tension de claquage entre la source et le substrat.

Or des régions de contact entre une couche d'oxyde mince et une zone d'oxyde épais sont pourvues de défauts qui perturbent les transferts des porteurs de charge, et l'on observe de telles régions de contact dans les structures classiques de mémoires non-volatiles programmables et électriquement effaçables, ou EEPROM, dans la technologie dite "FLOTOX".

L'intérêt présenté par l'architecture selon l'invention réside dans le fait que les régions d'oxyde mince où transitent les porteurs de charge ne sont jamais en contact ou à proximité d'une zone d'oxyde épais.

Il est ainsi possible de réaliser des mémoires dites "flash" de type EPROM effaçables électriquement par application d'une tension adaptée aux sources des transistors.

## Revendications

1. Mémoire composée d'un réseau de lignes de mot (LM1, LM2) s'étendant suivant une première direction, dite de rangée, reliant des grilles de commande (25) de transistors à grille flottante, et de lignes de bit (LB1, LB2) s'étendant suivant une deuxième direction, dite de colonne, reliant des drains des transistors à grille flottante, caractérisée en ce qu'une zone conductrice respective (35), de dimensions supérieures à celles de la grille flottante (23) des transistors suivant un plan horizontal, est reliée à la grille flottante de chaque transistor de la mémoire, tout en étant située en regard de la ligné de mot correspondante dont elle est séparée par une couche d'isolement (28).

2. Mémoire selon la revendication 1, caractérisée en ce que :

une ligne à potentiel constant (B), qui s'étend selon une colonne et est constituée par une diffusion d'un premier type de conductivité reliant les sources des transistors, est intercalée une fois sur deux entre deux lignes de bit, toutes les lignes à potentiel constant étant au même potentiel,

chaque transistor comprend une grille flottante (23) essentiellement constituée par un rectangle conducteur, une grille de commande (25) constituée par la partie de ligne de mot située sensiblement à l'emplacement de la grille flottante du transistor,

la zone conductrice (35) est constituée par un rectangle de dimensions supérieures à celles de la grille flottante (23) suivant la direction des rangées,

une zone d'isolement (24) s'étendant suivant une colonne est disposée du côté de chaque ligne de bit opposé à une ligne à potentiel constant.

3. Mémoire selon la revendication 2, caractérisée en ce qu'une zone supplémentaire (E) conductrice recouvre les bords longitudinaux des zones d'isolement (24), cette zone supplémentaire (E) étant composée du même matériau que celui constituant les grilles flottantes (23) des transistors.

4. Mémoire selon l'une quelconque des revendications 2 ou 3, caractérisée en ce que, dans un transistor, la zone conductrice (35), de dimensions suivant la direction des colonnes sensiblement égales à celles de la ligne de mot et de la grille flottante, déborde de part et d'autre de la grille flottante suivant la direction des rangées, en dépassant la grille flottante d'une première longueur (a) du côté de la ligne à potentiel constant, et en remontant sur la zone d'isolement (24) et la zone supplémentaire (E) adjacentes au transistor en dépassant la zone supplémentaire (E) d'une deuxième longueur (b).

5. Mémoire selon l'une quelconque des revendications 1 à 4, caractérisée en ce que les grilles flottantes (23), les zones conductrices (35) et les lignes de mot (LMi) sont réalisées respectivement par des premier, deuxième et troisième niveaux de silicium polycristallin.

6. Mémoire selon l'une quelconque des revendications 2 à 5, caractérisée en ce que les zones d'isolement (24) sont réalisées par de l'oxyde de silicium épais.

7. Procédé de fabrication de mémoire, de type MOS à transistors à grille flottante disposés selon des rangées et des colonnes sur un substrat d'un premier type de conductivité, comprenant les étapes suivantes :
   - réaliser des zones d'oxyde épais (24) selon des colonnes,
   - déposer et graver un premier niveau de silicium polycristallin pour former selon des colonnes d'une part deux premières bandes adjacentes entre chaque paire de colonnes d'oxyde épais, d'autre part deux deuxièmes bandes dont chacune est à cheval entre la partie comprise à l'intérieur de cette paire et une partie de la zone d'oxyde épais correspondante,
   - réaliser une implantation du deuxième type de conductivité en utilisant le premier niveau de silicium polycristallin comme masque,
   - former une couche d'isolement (36) entre les différentes zones de premier niveau de silicium polycristallin, caractérisé en ce qu'il comprend en outre les étapes suivantes :
   - déposer un deuxième niveau de silicium polycristallin (35′) et l'isoler superficiellement (28),
   - graver le deuxième niveau de silicium polycristallin (35) pour qu'il recouvre selon des colonnes des première et deuxième bandes adjacentes du premier niveau de silicium polycristallin,
   - isoler latéralement les régions apparentes du deuxième niveau de silicium polycristallin,
   - déposer un troisième niveau de silicium polycristallin,
   - graver par un même masque, selon des rangées, les trois niveau de silicium polycristallin,
   - former une couche isolante, et
   - établir des contacts avec les bandes restantes du troisième niveau de silicium polycristallin (lignes de mot), les colonnes de drains (lignes de bit), et les colonnes de sources (lignes à potentiel constant).

8. Procédé de fabrication de mémoire selon la revendication 7, caractérisé en ce que l'isolement entre les deuxième et troisième niveaux de silicium polycristallin est constitué par un empilement de trois couches : oxyde de silicium/nitrure de silicium/oxyde de silicium, appelé ONO.

9. Procédé de fabrication de mémoire selon la revendication 7, caractérisé en ce que la couche d'isolement entre les zones du premier niveau de silicium polycristallin est constituée d'oxyde de silicium obtenu par dépôt en phase vapeur à partir d'une source TEOS (tétraéthyle ortho silicate) et est réalisée par un procédé de planarisation qui permet d'amener les surfaces supérieures de cette couche (36) et du premier niveau de silicium polycristallin au même niveau.

**Claims**

1. A memory comprising an array of word lines (LM1, LM2), extending along a first direction, called row direction, connecting the control gates (25) of the floating gate transistors, and bit lines (LB1, LB2) extending along a second direction, called column direction, connecting the drains of the floating gate transistors, characterized in that a respective conductive area (35) having a larger size than that of the floating gate (23) of the transistors along a horizontal direction, is connected to the floating gate of each transistor of the memory, and is in register with the corresponding word line from which it is separated by an isolation layer (28).

2. A memory according to claim 1, characterized in that:

a constant-potential line (B), extending along a column and made by a diffusion of a first conductivity type connecting the transistor sources, is arranged between each pair of bit lines, all the constant-potential lines being at the same potential,

each transistor comprises a floating gate (23) mainly corresponding to a conductive rectangle, a control gate (25) corresponding to the portion of bit line substantially arranged at the position of the transistor floating gate,

the conductive area (35) corresponds to a rectangle having a size higher than the size of the floating gate (23) along the row direction,

an isolation area (24) extending along a column is arranged on the side of each bit line opposed to a constant-potential line.

3. A memory according to claim 2, characterized in that an additional conductive area (E) covers the longitudinal sides of the isolation areas (24), this additional area (E) being made of the same material as the one constituting the floating gates (23) of the transistors.

4. A memory according to claim 2 or 3, characterized in that, in a transistor, the conductive area (35), having a size along the column direction substantially equal to the size of the word line and of the floating gate, extends on both sides of the floating gate along the row direction, extending away from the floating gate according to a first length (a) on the side of the constant-potential line, and extending onto the isolation area (24) and the additional area (E) adjacent to the transistor and further extending on the additional area (E) according to a second length (b).

5. A memory according to any of claims 1 to 4, characterized in that the floating gates (23), the conductive areas (35) and the word lines (LMi) are made by first, second and third polysilicon levels, respectively.

6. A memory according to any of claims 2 to 5, characterized in that the isolation areas (24) are made of thick silicon oxide.

7. A method for manufacturing a memory comprising floating gate MOS transistors arranged according to rows and columns on a substrate of the first conductivity type, comprising the following steps:

- forming thick oxide areas (24) according to columns,

- depositing and etching a first polysilicon level for forming according to columns, on the one hand, two first adjacent stripes between each pair of thick oxide columns and, on the other hand, two second stripes, each one extending on the portion included inside this pair and the portion of the corresponding thick oxide area.

- implanting a dopant of the second conductivity type by using the first polysilicon level as a mask,

- forming an isolation layer (36) between the various areas of the first polysilicon level,

characterized in that it further comprises:

- depositing a second polysilicon level (35') and isolating its surface (28),

- etching the second polysilicon level (35) for having it cover according to columns the first and second adjacent stripes of the first polysilicon level,

- laterally isolating the apparent areas of the second polysilicon level,

- depositing a third polysilicon level,

- etching with the same mask, according to rows, the three polysilicon levels,

- forming an isolating layer, and

- establishing contacts with the remaining stripes of the third polysilicon level (word line), the drain columns (bit lines) and the source columns (constant-potential lines).

8. A manufacturing method according to claim 7, characterized in that the isolation between the second and third polysilicon levels is made by piling up three layers: silicon oxide, silicon nitride, silicon oxide (ONO).

9. A manufacturing method according to claim 8, characterized in that the isolation layer between the areas of the first polysilicon level is constituted by silicon oxide obtained by chemical vapor deposition from a TEOS source (tetraethyl ortho silicate) and is carried out by a planarization process which permits to have the upper surfaces of this layer (36) and the upper surfaces of the first polysilicon level at the same level.

**Patentansprüche**

1. Speicher mit einem Netz aus Wortlinien (LM1, LM2), die sich in einer ersten Richtung, der sogenannten Zeilenrichtung erstrecken und die Steuergitter (25) von Transistoren mit schwebendem Gitter verbinden, und aus Bitlinien (LB1, LB2), die sich in einer zweiten Richtung, der sogenannten Spaltenrichtung erstrecken und die Drainelektroden der Transistoren mit schwebendem Gitter verbinden, dadurch gekennzeichnet, daß eine entsprechende leitende Zone (35), deren Dimensionen in einer horizontalen Ebene größer sind als diejenigen des schwebenden Gitters (23) der Transistoren, mit dem schwebenden Gitter eines Jeden Transistors des Speichers verbunden und längs der entsprechenden Wortlinie ausgerichtet ist, von der sie durch eine Isolationsschicht (28) getrennt ist.

2.  Speicher nach Anspruch 1, dadurch gekennzeichnet, daß:
    eine Linie mit konstantem Potential (B), die sich längs einer Spalte erstreckt und durch eine Diffusion eines ersten Leitungstypes zur Verbindung der Sourceelektroden der Transistoren gebildet ist, Jeweils zwischen einem Paar aus zwei Bitlinien angeordnet ist, wobei alle Linien mit konstantem Potential auf dem gleichen Potential liegen,
    jeder Transistor ein schwebendes Gitter (23), das im wesentlichen durch ein leitendes Rechteck gebildet ist, und ein Steuergitter (25) aufweist, das durch den Teil der Wortlinie gebildet ist, die im wesentlichen am Ort des schwebenden Gitters des Transistors gelegen ist,
    die leitende Zone (35) durch ein Rechteck gebildet ist, dessen Dimensionen in Zeilenrichtung größer als diejenigen des schwebenden Gitters (23) sind,
    eine Isolationszone (24), die sich längs einer Spalte erstreckt, jeweils auf der Seite einer jeden Bitlinie angeordnet ist, die der Linie mit konstantem Potential gegenüberliegt.

3.  Speicher nach Anspruch 2, dadurch gekennzeichnet, daß eine zusätzliche leitende Zone (E) die Längsränder der Isolationszonen (24) überdeckt, wobei diese zusätzliche Zone (E) aus dem gleichen Material aufgebaut ist, aus dem die schwebenden Gitter (23) der Transistoren bestehen.

4.  Speicher nach einem der Ansprüche 2 oder 3, dadurch gekennzeichnet, daß in einem Transistor die leitende Zone (35), die in Spaltenrichtung im wesentlichen die gleichen Dimensionen wie die Wortlinie und das schwebende Gitter hat, das schwebende Gitter in Zeilenrichtung beidseitig überragt, wobei sie über das schwebende Gitter mit einer ersten Länge (a) auf der Seite der Linie mit konstantem Potential herausragt und über der Isolationszone (24) und der zusätzlichen Zone (E), die sich an den Transistor anschließen, ansteigt und dabei über die zusätzliche Zone (E) um eine zweite Länge (b) herausragt.

5.  Speicher nach einem der Ansprüche 1 bis 4, dadurch gekennzeichnet, daß die schwebenden Gitter (23), die leitenden Zonen (35) und die Wortlinien (LMi) durch ein erstes, zweites bzw. drittes Niveau aus polykristallinem Silizium gebildet sind.

6.  Speicher nach einem der Ansprüche 1 bis 5, dadurch gekennzeichnet, daß die Isolationszonen (24) aus einem dicken Siliziumoxid gebildet sind.

7.  Verfahren zur Herstellung eines Speichers vom Typ MOS mit Transistoren mit schwebendem Gitter, die auf einem Substrat eines ersten Leitungstyps längs Zeilen und Spalten angeordnet sind, mit folgenden Schritten:
    - Ausbilden von Zonen eines dicken Oxids (24) längs der Spalten,
    - Aufbringen und Ätzen eines ersten Niveaus aus polykristallinem Silizium, um längs der Spalten einerseits zwei erste benachbarte Streifen zwischen jedem Paar von Spalten des dicken Oxids und andererseits zwei zweite Streifen auszubilden, von denen jeder den Bereich innerhalb dieses Paares und einen Bereich der entsprechenden dicken Oxidzone überdeckt,
    - Implantieren eines zweiten Leitungstypes, wobei das erste Niveau aus polykristallinem Silizium als Maske verwendet wird,
    - Ausbilden einer Isolationsschicht (36) zwischen den unterschiedlichen Zonen des ersten Niveaus aus polykristallinem Silizium,
    dadurch gekennzeichnet, daß noch die folgenden Schritte vorliegen:
    - Aufbringen eines zweiten Niveaus aus polykristallinem Silizium (35') und Isolieren von dessen Oberfläche (28),
    - Ätzen des zweiten Niveaus aus polykristallinem Silizium (35), so daß dieses längs der Spalten die ersten und zweiten benachbarten Streifen des ersten Niveaus aus polykristallinem Silizium bedeckt,
    - Isolieren der Seiten der freiliegenden Bereiche des zweiten Niveaus aus polykristallinem Silizium,
    - Aufbringen eines dritten Niveaus aus polykristallinem Silizium,

- Ätzen der drei Niveaus aus polykristallinem Silizium längs der Zeilen mit einer Maske,
- Ausbilden einer Isolationsschicht und
- Einrichten von Kontakten mit den verbleibenden Streifen im dritten Niveau aus polykristallinem Silizium (Wortlinien), mit den Spalten der Drainelektroden (Bitlinien) und mit den Spalten der Sourceelektroden (Linien mit konstantem Potential).

8. Verfahren zur Herstellung eines Speichers nach Anspruch 7, dadurch gekennzeichnet, daß die Isolation zwischen dem zweiten und dritten Niveau aus polykristallinem Silizium durch einen ONO-Aufbau genannten Aufbau aus drei Schichten gebildet wird: Siliziumoxid/Siliziumnitrid/Siliziumoxid.

9. Verfahren zur Herstellung eines Speichers nach Anspruch 7, dadurch gekennzeichnet, daß die Isolationsschicht zwischen den Zonen des ersten Niveaus aus polykristallinem Silizium aus Siliziumoxid gebildet wird, das durch Abscheiden aus der Dampfphase von einer ersten TEOS-Quelle (Tetraethylorthosilikat) stammt, und durch ein Planarisierungsverfahren realisiert wird, wodurch die Oberflächen dieser Schicht (36) und des ersten Niveaus aus polykristallinem Silizium auf gleiches Niveau gebracht werden können.

Figure 1A

Figure 1B

Figure 2

EP 0 354 858 B1

LB2

LB3

LM1

14

2

1  6  5

13

T12

13

T13

5

13

## Figure 3

LB2

14

2

6

1

5

N⁺

N⁺

N⁺

3

T12

7

4

11

7

T22

3

## Figure 4

EP 0 354 858 B1

Figure 5A

Figure 5B

Figure 6A

Figure 6B

Figure 6C

Figure 6D

Figure 6E

Figure 6F

Figure 6G

Figure 7

Figure 8A

Figure 8B

Figure 9